# EUROPÄISCHE PATENTSCHRIFT

(11) **EP 0 770 452 B1**
(45) Veröffentlichungstag und Bekanntmachung des Hinweises auf die Patenterteilung: **14.07.1999**
(21) Anmeldenummer: 96116548.7
(22) Anmeldetag: 16.10.1996
(51) Int. Cl.: B23Q 1/34, H01L 41/09

(54) **Schwenkantrieb**
Pivotable actuator
Organe d'entraînement pivotant

(30) Priorität: 20.10.1995 DE 19539201
(43) Veröffentlichungstag der Anmeldung: 02.05.1997
(73) Patentinhaber: Deutsches Zentrum für Luft- und Raumfahrt e.V., 53175 Bonn (DE)
(72) Erfinder: Breitbach, Elmar J., 37075 Göttingen (DE); Büter, Andreas, 38102 Braunschweig (DE)
(74) Vertreter: Einsel, Martin, Dipl.-Phys.

(56) Entgegenhaltungen:
- WO-A-96/01503
- US-A- 5 396 714

## Beschreibung

Die Erfindung betrifft einen Schwenkantrieb mit einem Stab und einem Aktuator Zur Einleitung von Längskräften in den Stab.

Die Erfindung betrifft insbesondere einen Schwenkantrieb für schnelle und positionsgenaue Drehbewegungen um einen begrenzten Winkelbetrag. Anwendungsbereiche sind beispielsweise die Meß- und Versuchstechnik, die Handhabungstechnik, die Luft- und Raumfahrt, die Robotik und die Medizintechnik.

Schwenkantriebe zur Erzeugung von Schwenkbewegungen in einem Winkelbereich bis zu 360° sind im Stand der Technik vielfach bekannt. Die bekannten Schwenkantriebe haben hydraulische, pneumatische oder elektromagnetische Stellglieder. Die Wirtschaftlichkeit des Einsatzes einer bestimmten Ausbildung des Stellgliedes hängt neben den konstruktiven Anforderungen stark vom Aufbau des bestehenden Systems ab. So ist beispielsweise der Einsatz hydraulischer oder pneumatischer Antriebe nur dann wirtschaftlich sinnvoll, wenn im bestehenden System bereits ein Hydraulik- oder ein Pneumatikkreislauf vorgesehen ist.

Speziell bei hydraulischen Schwenkantrieben ist es nachteilig, daß das unter Druck stehende Hydraulikmedium aufgrund seiner Kompressibilität ein gegenüber einer Stahlsäule weicheres Verhalten hat. Die Kompressibilität wird außerdem durch die im Hydrauliksystem vorhandene Luft erhöht. Durch das Vorhandensein von Luft im Hydrauliksystem ergibt sich ein ruckweises Arbeiten. Insgesamt werden die Umsteuerzeiten verlängert. Darüberhinaus bedingen Leckverluste und die dargestellte Kompressibilität, daß der hydraulische Antrieb für viele Anwendungen nicht ausreichend formschlüssig ist. Für eine präzise Positionierung müssen daher zusätzliche steuerungs- und/oder regelungstechnische Maßnahmen vorgesehen werden, was die Herstellungskosten und die laufenden Wartungskosten sowie die Störanfälligkeit erhöht.

Die bekannten pneumatischen Schwenkantriebe zeigen ähnliche Nachteile wie die hydraulischen Antriebe. Darüberhinaus ist bei Druckluftantrieben nachteilig, daß die Stelltriebe relativ große Abmessungen haben und die Gefahr von Vereisungen, insbesondere an Auslaßöffnungen, besteht. Ferner ist es nötig, daß zur Schmierung der Bauteile die Druckluft mit Öl angereichert wird, wodurch Umweltbeeinträchtigungen bzw. Belästigungen durch den in der Abluft enthaltenen Ölnebel entstehen, so daß die in der Luft mitgeführten Verunreinigungen und das Kondenswasser abgeschieden werden müssen. Weiter ist eine erhöhte Belästigung durch die Abluftgeräusche zu berücksichtigen. Insgesamt ist die Wirtschaftlichkeit pneumatischer Schwenkantriebe unter Berücksichtigung der relativ hohen Energiekosten schlecht.

Für besonders präzise Positionieraufgaben bei elektromagnetischen Schwenkantrieben werden Schrittmotoren verwendet. Im Gegensatz zu Elektromotoren mit Motorlagegebern werden Schrittmotoren in einer offenen Steuerkette betrieben, womit keine Rückmeldung erfolgt, ob der Läufer auch tatsächlich die vorgegebene Position erreicht hat. Daher muß sichergestellt sein, daß der Motor stets die gewünschte Anzahl Schritte vollführt. Insbesondere zeigen Schrittmotoren Anlaufprobleme, außer Tritt-Fallen bei Überlast und Schwingverhalten bei plötzlichen Zustandsänderungen. Schrittmotoren eignen sich daher auch nur bedingt zur genauen Positionierung an Schwenkantrieben.

Aus der US-PS 4,857,791 ist ein Linearmotor bekannt. Bei diesem wird eine im Querschnitt H-förmige Konstruktion zu Schwingungen angeregt, indem ein zwischen zwei Armen des H angeordneter Vibrator die Gesamtkonstruktion zu Schwingungen anregt und jeder der beiden vom Aktuator abgewandten Arme mit unterschiedlicher Resonanzfrequenz versehen ist. Je nach der Schwingungsfrequenz des Vibrators wird dadurch eine Vorwärts- bzw. Rückwärtsbewegung des Gesamtmotors erzeugt.

Aus der DE 36 02 673 A1 ist ein piezoelektrisches Betätigungsglied bekannt. Durch ein System schwenk- bzw. drehbar gelagerter Hebel, die miteinander kombiniert und in Verbindung sind, wird dort eine Kraftausübung auf ein Ende eines der Hebel in einer Schwenkung eines anderen, um einen anderen Drehpunkt gelagerten Hebels umgesetzt. Dadurch lassen sich interessante Verstärkungseffekte erzielen. Der verhältnismäßig komplizierte Mechanismus basiert in erster Linie auf dem Verstärkungseffekt nicht gleich langer Hebelarme und kann im Hinblick auf die empfindlichen Schwenklagerbereiche zu Ermüdungseffekten neigen.

Aus dem Artikel von Zurhorst und Öry, "Active Twist Control of a Windtunnel Model Wing", veröffentlicht in "Proceedings International Forum on Aero-Elasticity and Structural Dynamics", 1991 ist eine Anwendung zur aktiven Verwindungskontrolle bekannt, bei dem ein viergurtiger Kastenträger durch diskret eingebrachte Wölbverformungen die Verwindung an einem Windkanalmodellflügel kontrolliert. Die Wölbverformungen wurden in den als Flügeltorsionskasten verwendeten Kastenträger so eingeleitet, daß die durch äußere Kräfte erzeugte Verwindung, beispielsweise durch einen Querruderausschlag von 20° bei einer Luftgeschwindigkeit von 67 m/s, korrigiert wird. Mit der möglichst biegesteifen Flügelstruktur sollen unerwünschte Verwindungen des Flügels kontrolliert werden. Eine exakte und direkt abgreifbare Drehbewegung kann dieses Bauteil nicht erzeugen.

Aus wissenschaftlichen Abhandlungen, beispielsweise aus Wlassow, W. S., dünnwandig elastische Stäbe, Band 1, VEB Verlag für Bauwesen Berlin 1964, ist die Wölbkrafttorsion als unerwünschtes Phänomen an dünnwandigen Stäben bekannt. Die Wölbkrafttorsion wird dort auch für offene Profile, wie beispielsweise ein geschlitztes Kreisprofil, mathematisch hergeleitet.

Aufgabe der Erfindung ist es, einen Schwenkantrieb anzugeben, der eine schnelle, exakte und direkt abgreifbare Drehbewegung erzeugt, wobei die Verstellposition wiederholbar genau angefahren wird, so daß überwachungs- und regelungstechnische Maßnahmen am Schwenkantrieb unnötig sind.

Gelöst wird diese Aufgabe dadurch, daß der Stab mit einem Querschnitt ausgeführt ist, bei dem eine außermittige Längskrafteinleitung in den Stab eine Verdrehung der Stabenden zueinander bewirkt.

Die Erfindung arbeitet also durch Ausnutzung der Wölbkrafttorsion, die mittels eines Aktuators in einen Stab mit nicht wölbfreiem Querschnitt eingeleitet wird.

Mit der Einleitung von Bimomenten in einen wölbfähigen Stab verdrehen sich die Stabenden zueinander. Somit kann ein Schwenkantrieb realisiert werden, der eine schnelle, stetige und positionsgenaue Schwenkbewegung bei maximaler Torsionssteifigkeit des Drehelementes vollführt.

Wenn der Querschnitt des Stabes offen ausgebildet ist, können die durch den Aktuator aufgebrachten, erforderlichen Wölbkräfte klein gehalten werden. Insbesondere ein als geschlitztes Rohr ausgebildeter Stab ist in bezug auf die gewünschte Verwölbung sehr weich, d. h., ein erwünschter Drillwinkel wird bereits mit geringen die Verwölbung erzeugenden Längskräften hervorgerufen.

Dadurch, daß mehrere Stäbe zur Erhöhung des erreichbaren Drehwinkels in - Reihe - geschaltet sind, wobei vorzugsweise die Stäbe ineinandergesteckt sind, summieren sich die einzelnd erreichbaren Drehwinkel auf, so daß bei einem vorgegebenen Verschwenkungswinkel die Einbaulänge des Schwenkantriebes verringert werden kann. Der Schwenkantrieb ist somit kaskadenförmig aufgebaut, wobei die in Reihe geschalteten Stabelemente vorzugsweise in geeigneter Steckbauweise miteinander gekoppelt sind.

Alternativ kann dabei jedem Stabelement oder jeweils zwei Stabelementen ein Aktuator zugeordnet werden. Im letzteren Fall ist es vorteilhaft, wenn zwei, vorzugsweise um 180° zueinander verdrehte, geschlitzte Rohre ineinander gesteckt sind, wobei zwischen den Rohren ein eine Längsverformung erzeugendes Aktuatorrohr angeordnet ist, wobei die Längsverformung mit Übertragungselementen in die Rohre eingeleitet wird. Die beiden ineinander gesteckten Rohre erzeugen bei den eingeleiteten Bimomenten gegenläufige Biegemomente, die sich je nach Ausbildung der Rohre weitestgehend aufheben. Die an den Rohren bei der Verwölbung auftretenden Biegemomente werden zusätzlich von dem zwischen den Rohren angeordneten Aktuatorrohr abgestützt. Die relativ zueinander auftretenden Verdrehungen der Rohrenden werden mit den Übertragungselementen ein- und weitergeleitet. Vorzugsweise sind daher die Übertragungselemente nahe den Enden der Rohre angeordnet und als Ringe ausgebildet, wobei an Abstützungsstellen der zueinander bzw. zum Aktuatorrohr verdrehbaren Ringe Gleitlager vorgesehen sind. Die Gleitlager erlauben die Verdrehungen der Ringe zueinander bei gleichzeitiger Abstützung.

Die Wölbverformungen lassen sich problemlos durch Gleichgewichtskraftgruppen am Spalt der geschlitzten Rohrelemente einleiten. Dabei sind die Angriffspunkte für die Längskräfte so angeordnet, daß sie auf beiden Seiten des Schlitzes zu liegen kommen. Zur Erzeugung einer bestimmten Verdrehung muß jedoch die entsprechende Wölbverformung über eine maximale Längsverformung an den Angriffspunkten erzeugt werden. Um die aufzubringenden Längsverformungen klein zu halten, ist es daher vorteilhaft, daß ein Angriffspunkt zur Einleitung der durch den Aktuator erzeugten Längskräfte etwa 90° versetzt zum Schlitz angeordnet ist.

Insbesondere bei einem rohrförmig ausgebildeten Aktuator ist es vorteilhaft, die gewünschte Längsverformung durch piezokeramische oder magnetostriktive Elemente hervorzurufen. Derartige Elemente arbeiten verzögerungsfrei und erlauben eine definierte Längsverformung zur präzisen Ansteuerung des Schwenkantriebes. Der dafür erforderliche elektrische Ansteuerungsaufwand ist gering. Das Aktuatorrohr ist vorzugsweise aus diesen Elementen so aufgebaut, daß der kreisringförmige Querschnitt zwischen den beiden, als geschlitzte Rohre ausgebildeten Stäben nahezu ausgefüllt ist. Damit werden die Rohre vom Aktuatorrohr geführt und gestützt.

Nachfolgend wird eine bevorzugte Ausführungsform der Erfindung anhand der Zeichnungen detailliert beschrieben. Darin zeigt:
- Fig. 1: einen erfindungsgemäßen Schwenkantrieb in teils geschnittener Seitenansicht und
- Fig. 2: einen entlang der in Fig. 1 dargestellten Linie A - A genommenen Querschnitt des Schwenkantriebes.

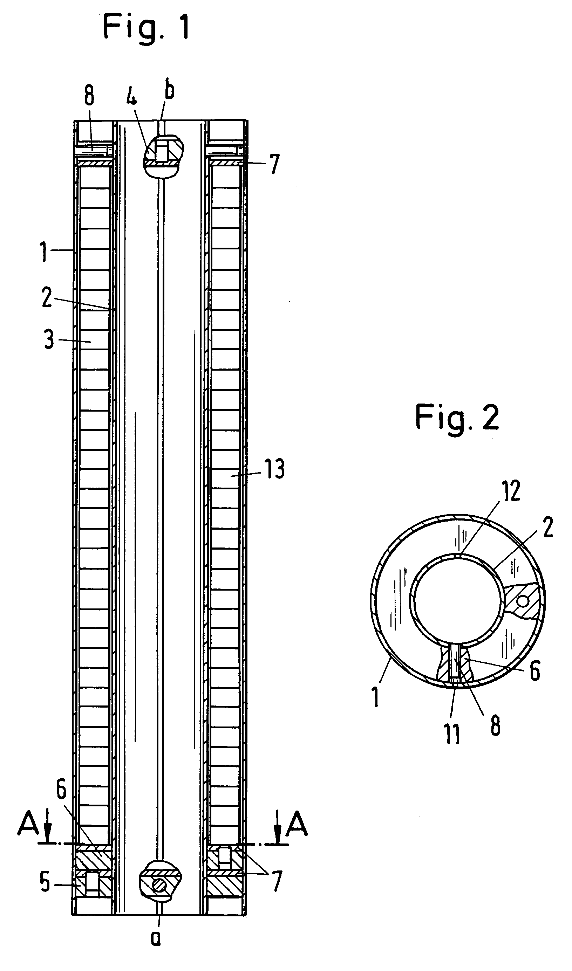

Der in Fig. 1 dargestellte Schwenkantrieb weist ein äußeres Rohr 1 und ein konzentrisch dazu angeordnetes inneres Rohr 2 mit kleinerem Durchmesser auf. Im kreisringförmigen Zwischenraum zwischen dem äußeren Rohr 1 und dem inneren Rohr 2 ist ein Aktuatorrohr 3 vorgesehen. Das Aktuatorrohr 3 besteht z.B. aus kreisringförmig ausgebildeten piezokeramischen Elementen 13, die in geeigneter Weise elektrisch verdrahtet sind (nicht dargestellt). Das äußere Rohr 1 weist einen Hohlprofilquerschnitt auf, der offen, nämlich durch einen Längsschlitz 11, ausgebildet ist. Ebenso weist das innere Rohr 2 einen das Rohr in Längsrichtung durchtrennenden Schlitz 12 auf.

Auf der Unterseite der Rohre 1, 2, dem Rohrende a, stützt sich das Aktuatorrohr 3 über zwei kreisringförmige Übertragungselemente 5, 6 an den Enden der Rohre ab. Am oberen Rohrende b ist ein ebenfalls kreisringförmiges Übertragungselement 4 vorgesehen, das die Längsverformung des Aktuatorrohres 3 als Verwölbung in die Rohre 1, 2 einleitet. Das kreisringförmige Übertragungselement 5 ist vorzugsweise mittels eines Stiftes 8 mit dem äußeren Rohr 1 an einem Angriffspunkt für die einzuleitende Längskraft drehfest verbunden. Dieser Angriffspunkt ist hier vorzugsweise der Querschnittspunkt ("Aufpunkt" genannt), bei dem bei einer Profilverdrehung keine Wölbverformung auftritt. Auf der nach oben zeigenden Kreisringfläche des Übertragungselementes 5 ist ein Gleitlager 7 angeordnet, auf dem das darüber angeordnete Übertragungselement 6 gleitend verdrehbar abgestützt ist. Das Übertragungselement 6 ist ebenfalls vorzugsweise mit einem Stift 8 mit dem inneren Rohr 2 an einem Angriffspunkt (Aufpunkt des Profilquerschnitts) für die dort einzuleitende Längskraft drehfest verbunden. Auf der kreisringförmigen Oberfläche des Übertragungselementes 6 ist wiederum ein Gleitlager 7 befestigt. Hierauf stützt sich das Aktuatorrohr 3 gleitend verdrehbar ab.

Am gegenüberliegenden Rohrende b ist das kreisringförmige Übertragungselemente 4 vorzugsweise jeweils mit einem Stift 8 mit dem äußeren Rohr 1 und dem inneren Rohr 2 drehfest verbunden. Der Stift 8 am äußeren Rohr 1 bildet den Angriffspunkt für die in das Rohr 1 einzuleitende Längskraft, um die Verwölbung zu erzeugen. Der Angriffspunkt (Stift 8) ist um 90° versetzt zum Schlitz 11 angeordnet. Ebenso bildet der Stift 8 am inneren Rohr 2 den Angriffspunkt zur Einleitung der die Verwölbung des inneren Rohres 2 hervorrufenden Längskraft. Auch dieser Angriffspunkt (Stift 8) ist um 90° versetzt zum Schlitz 12 angeordnet. Durch den um den Winkelbetrag von 90° zum Schlitz 11 bzw. 12 versetzten Angriffspunkt für die Längskraft ist zur Erzeugung eines vorgegebenen Drehwinkels und damit einer entsprechenden Wölbverformung nur eine relativ geringe Längsverformung nötig. Die maximale, am Schlitz 11 bzw. 12 auftretende Längsverformung muß daher nicht vom Aktuatorrohr 3 erzeugt werden. Auf der kreisringförmigen Unterseite des Übertragungselementes 4 ist ebenfalls ein Gleitlager 7 angeordnet, an dem sich die Oberseite des Aktuatorrohres 3 gleitend verdrehbar abstützt.

Nachfolgend wird die Funktionsweise des Aktuators detailliert beschrieben.

Durch das Aktuatorrohr 3 wird eine Längsverformung erzeugt, wobei die Längsverformung über die Gleitlager 7 und die Übertragungselemente 4, 5 und 6 sowie die dort befestigten Stifte 8 auf die Rohre 1, 2 übertragen wird. Da die Rohre 1, 2 Längsschlitze 11, 12 aufweisen und die Krafteinleitung nicht wölbfrei ist, tritt eine Verwölbung der Rohre 1, 2 auf. Vom am Rohrende a abgestützten Aktuatorrohr wird im äußeren Rohr 1 durch die Krafteinleitung eine Verwölbung erzeugt, so daß das obere Rohrende b des äußeren Rohres 1 verdreht wird.

Über das Übertragungselement 4 wird das obere Rohrende b des inneren Rohres 2 um diesen entsprechenden Drehwinkel verdreht. Die durch das Aktuatorrohr erzeugte Längenänderung wirkt jedoch auch durch die Abstützungen auf das innere Rohr 2, so daß zusätzlich zum Verdrillwinkel des äußeren Rohres 1 eine Verwölbung im inneren Rohr 2 entsteht. Das untere Rohrende a des inneren Rohres verdreht sich somit um einen weiteren Winkelbetrag. Insgesamt ist damit zwischen dem äußeren Rohr 1 und dem inneren Rohr 2 am unteren Rohrende a ein Verschwenkungsbetrag abgreifbar, der zur mit dem Aktuatorrohr 3 eingeleiteten Kraft proportional ist.

Mit diesem Schwenkantrieb sind daher sehr präzise Verschwenkungen ansteuerbar. Es ist möglich, einen genau vorgegebenen Drehwinkelbetrag mit dem Schwenkantrieb anzusteuern. Es ist also eine sehr präzise Drehung durch relativ geringe Kräfteeinleitung möglich. Durch das zwischen dem äußeren und dem inneren Rohr angeordnete Aktuatorrohr wird die Vorrichtung trotz der Schlitzung wölbunempfindlich und somit torsionssteif. Lediglich für die absichtlich eingeleitete und somit zugelassene Verwölbung verhalten sich die geschlitzten Rohre ausgesprochen weich.

Durch ein mehrfaches Ineinanderstecken derartiger Anordnungen kann eine Kaskadierung, also eine Addition der erreichbaren Drehwinkel erzeugt werden. Somit ist es auch möglich, die Baulänge des Schwenkantriebes bei vorgegebenen Drehwinkel zu reduzieren.

### Bezugszeichenliste

- 1: äußeres Rohr
- 2: inneres Rohr
- 3: Aktuator(rohr)
- 4: Übertragungselement, Ring
- 5: Übertragungselement, Ring
- 6: Übertragungselement, Ring
- 7: Gleitlager
- 8: Angriffspunkt, Stift
- 11: Schlitz
- 12: Schlitz
- 13: piezokeramisches Element
- a: unteres Rohrende
- b: oberes Rohrende

## Patentansprüche

1. Schwenkantrieb mit einem Stab (1,2) und einem Aktuator (3) zur Einleitung von Längskräften in den Stab (1, 2),
**dadurch gekennzeichnet,**
**daß** der Stab (1, 2) mit einem Querschnitt ausgeführt ist, bei dem eine außermittige Längskrafteinleitung in den Stab eine Verdrehung der Stabenden zueinander bewirkt.

2. Schwenkantrieb nach Anspruch 1,
**dadurch gekennzeichnet,**
**daß** der Querschnitt des Stabes (1, 2) offen ausgebildet ist.

3. Schwenkantrieb nach Anspruch 2,
**dadurch gekennzeichnet,**
**daß** der Stab (1, 2) als Rohr ausgebildet ist, das einen in Längsrichtung angeordneten, durchgehenden Schlitz (11, 12) hat.

4. Schwenkantrieb nach Anspruch 1, 2 oder 3,
**dadurch gekennzeichnet,**
**daß** mehrere Stäbe (1, 2) zur Erhöhung des erreichbaren Drehwinkels in - Reihe - geschaltet sind, wobei vorzugsweise die Stäbe ineinandergesteckt sind.

5. Schwenkantrieb nach Anspruch 4,
**dadurch gekennzeichnet,**
**daß** jedem Stab ein Aktuator (3) zugeordnet ist.

6. Schwenkantrieb nach Anspruch 4,
**dadurch gekennzeichnet,**
**daß** jeweils zwei Stäben (1, 2) ein Aktuator (3) zugeordnet ist.

7. Schwenkantrieb nach Anspruch 3 und 6,
**dadurch gekennzeichnet,**
**daß** zwei, vorzugsweise um 180° zueinander verdrehte, geschlitzte Rohre (1, 2) ineinander gesteckt sind, wobei zwischen den Rohren (1, 2) ein eine Längsverformung erzeugendes "Aktuatorrohr" (3) angeordnet ist, wobei die Längsverformung mit Übertragungselementen (4, 5, 6) in die Rohre (1, 2) eingeleitet wird.

8. Schwenkantrieb nach Anspruch 7,
**dadurch gekennzeichnet,**
**daß** die Übertragungselemente (4, 5, 6) nahe den Enden (a, b) der Rohre (1, 2) angeordnet und als Ringe ausgebildet sind, wobei an Abstützungsstellen der zueinander bzw. zum Aktuatorrohr (3) verdrehbaren Ringe (4, 5, 6) Gleitlager (7) vorgesehen sind.

9. Schwenkantrieb nach Anspruch 3, 4, 5, 6, 7 oder 8,
**dadurch gekennzeichnet,**
**daß** ein Angriffspunkt zur Einleitung der durch den Aktuator (3) erzeugten Längskräfte etwa 90° versetzt zum Schlitz (11, 12) angeordnet ist.

10. Schwenkantrieb nach einem der Ansprüche 1 bis 9,
**dadurch gekennzeichnet,**
**daß** ein piezokeramischer oder magnetostriktiver Aktuator (3) vorgesehen ist.

11. Schwenkantrieb nach einem der Ansprüche 1 bis 10,
**dadurch gekennzeichnet,**
**daß** der Stab (1, 2) eine vorgespannte Verwölbung aufweist, um eine Verschwenkung von dieser Nullage in beide Drehrichtungen zu ermöglichen.

## Claims

1. A pivot drive with a rod (1,2) and an actuator (3) for the introduction of longitudinal forces into the rod (1,2) characterized in that the rod (1,2) has a cross-section whereby an eccentric introduction of longitudinal force into the rod effects a rotation of the rod ends relative to one another.

2. A pivot drive according to Claim 1, characterised in that the cross-section of the rod (1,2) is of open construction.

3. A pivot drive according to Claim 2, characterised in that the rod (1,2) is constructed in the form of a tube, which has a continuous slot (11,12) arranged in its longitudinal direction.

4. A pivot drive according to Claim 1,2 or 3, characterised in that a plurality of rods (1,2) are connected in series to increase the achievable angle of rotation, the rods preferably being fitted into one another.

5. A pivot drive according to Claim 4, characterised in that each rod has an actuator (3) associated therewith.

6. A pivot drive according to Claim 4, characterised in that an actuator (3) is associated with each pair of rods (1,2).

7. A pivot drive according to Claim 3 and 6, characterised in that two slotted tubes (1,2), preferably rotated 180E relatively to one another, are fitted into one another, an actuator tube (3) generating a longitudinal deformation being arranged between the tubes (1,2), the longitudinal deformation being introduced into said tubes (1,2) by means of transmission elements (4,5,6)

8. A pivot drive according to Claim 7, characterised in that the transmission elements (4,5,6) are arranged close to the ends (a,b) of the tubes (1,2) and constructed in the form of rings, sliding bearings (7) being provided at support points of the rings (4,5,6) which are rotatable relative to one another or relative to said actuator tube (3).

9. A pivot drive according to Claim 3,4,5,6,7 or 8, characterised in that a point of application is arranged displaced about 90E relative to the slot (11,12) for the introduction of the longitudinal forces generated by the actuator (3).

10. A pivot drive according to any one of Claims 1 to 9, characterised in that a piezo-ceramic or magnetostrictive actuator (3) is provided.

11. A pivot drive according to any one of Claims 1 to 10, characterised in that the rod (1,2) has a pre-tensioned curving in order to permit pivoting from its zero position in both directions of rotation.

## Revendications

1. Organe d'entraînement pivotant comprenant une barre (1, 2) et un actionneur (3) destiné à introduire des forces longitudinales dans la barre (1, 2), caractérisé en ce que la barre (1, 2) est exécutée avec une section par laquelle l'introduction excentrée d'une force longitudinale dans la barre entraîne une torsion des extrémités de la barre.

2. Organe d'entraînement pivotant selon la revendication 1, caractérisé en ce que la section de la barre (1, 2) est une section ouverte.

3. Organe d'entraînement pivotant selon la revendication 2, caractérisé en ce que la barre (1, 2) est conçue en forme de tube, qui est muni d'une fente (11, 12) continue disposée en sens long.

4. Organe d'entraînement pivotant selon la revendication 1, 2 ou 3, caractérisé en ce que plusieurs barres (1, 2) sont montées - en série - pour augmenter l'angle de rotation pouvant être atteint, les barres étant de préférence enfichées les unes dans les autres.

5. Organe d'entraînement pivotant selon la revendication 4, caractérisé en ce que chaque barre est associée à un actionneur (3).

6. Organe d'entraînement pivotant selon la revendication 4, caractérisé en ce que chaque ensemble de deux barres (1, 2) est associé à un actionneur (3).

7. Organe d'entraînement pivotant selon les revendications 3 et 6, caractérisé en ce que deux tubes (1, 2) fendus, décalés de préférence de 180° l'un par rapport à l'autre, sont enfichés l'un dans l'autre, un 〈〈 tube actionneur 〉〉 (3), produisant une déformation dans le sens longitudinal, étant disposé entre les tubes (1, 2), la déformation dans le sens longitudinal étant introduite dans les tubes (1, 2) par l'intermédiaire d'éléments de transmission (4, 5, 6).

8. Organe d'entraînement pivotant selon la revendication 7, caractérisé en ce que les éléments de transmission (4, 5, 6) sont disposés à proximité des extrémités (a, b) des tubes (1, 2) et sont conçus sous forme de bagues, les zones d'appui des bagues rotatives (4, 5, 6) l'une par rapport à l'autre ou par rapport au tube actionneur (3) étant munies d'un palier lisse (7).

9. Organe d'entraînement pivotant selon la revendication 3, 4, 5, 6, 7 ou 8, caractérisé en ce qu'un point d'attaque, destiné à introduire les forces longitudinales produites par l'actionneur (3), est décalé de 90° par rapport à la fente (11, 12).

10. Organe d'entraînement pivotant selon l'une quelconque des revendications 1 à 9, caractérisé en ce qu'il est prévu un actionneur (3) piézocéramique ou magnétostrictif.

11. Organe d'entraînement pivotant selon l'une quelconque des revendications 1 à 10, caractérisé en ce que la barre (1, 2) présente un gauchissement précontraint, afin de pouvoir pivoter de la position de repos dans les deux sens de rotation.
